# EUROPEAN PATENT APPLICATION

(11) **EP 0 836 370 A1**
(43) Date of publication of application: **15.04.1998**
(21) Application number: 96116098.3
(22) Date of filing: 08.10.1996
(51) Int. Cl.: H05K 3/06, C23F 1/08

(54) **Method and system for etching substrates for printed circuit boards**

(71) Applicant: Tsubaki, Takanori, Kashiwa-shi, Chiba 277 (JP)
(72) Inventor: Tsubaki, Takanori, Kashiwa-shi, Chiba 277 (JP)
(74) Representative: Wagner, Karl H., Dipl.-Ing.

(57) **Abstract**

A method for etching upper and lower sides, separately, of substrates for printed circuit boards includes steps of etching the substrates in etching unit (U1) by spraying an etchant to the lower side of substrates while the substrates being conveyed horizontally by the conveyor (D) have the upper side thereof covered by surface protector (E) against application of the etchant spray. The substrates having the etched lower side thereof cleaned in etchant removing station (H) to remove the residual etchant, is reversed upside down by reversing mechanism (R). Then, the side, thus oriented downward and yet to etch, of the substrates is etched in etching unit (U2) while the already etched side is being covered by surface protector (E) against application of the etchant spray. Therefore, substrates can be uniformly etched, and the substrate reversing mechanism (R) can operate smoothly since no etchant remains sticking to the substrate reversing mechanism.

## Description

### BACKGROUND OF THE INVENTION

### a) Field of the Invention

The present invention relates to an improved method and system for etching substrates to form predetermined circuits on both sides of the substrates.

### b) Description of the Prior Art

For manufacture of many printed circuit boards on an industrial scale, a series of substrates for such circuit boards must be put into uniform contact with an etchant to assure a uniform product quality. The contact of the substrates with the etchant can generally be attained by two methods: Immersion and spray. Of course, both these two methods have merits and demerits. However, the spray etching method should preferably be adopted because a line production can be employed to etch many substrates continuously and the etching process can be easily observed and controlled. Along the production line, a series of substrates is carried at a constant speed and passed before many etchant spray nozzles. For contact of both sides of substrates with the etchant under same conditions, the substrates should preferably be held horizontally while being carried through the etching station.

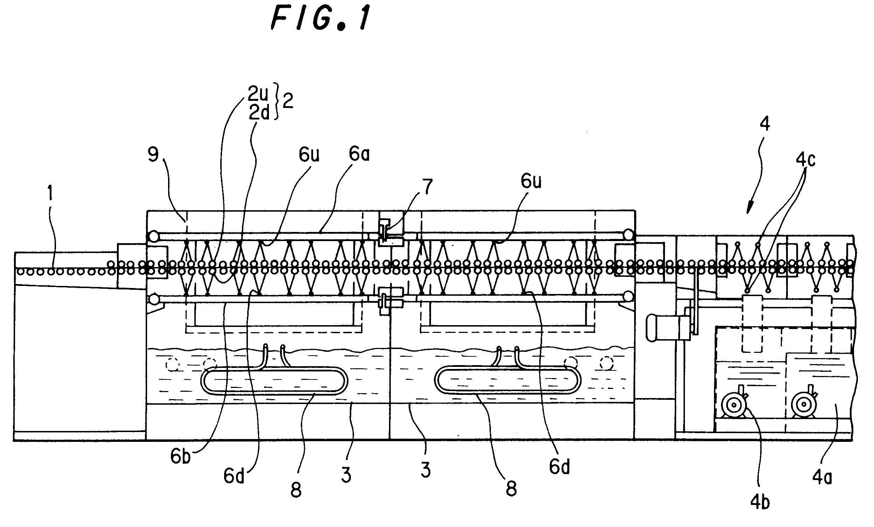

Fig. 1 shows a prior-art substrate etching system in which many substrates are applied with an etchant spray while being horizontally held and carried. In Fig. 1, substrates (not illustrated) are carried by an inlet conveyor 1 into an etching chamber of the substrate etching system from the left of the drawing. The substrates are carried on a roller conveyor 2 toward the right of the drawing. During this conveyance, the substrates are applied with the etchant spray and then cleaned by washing with a jet spray of water as will be described below. It should be noted that the roller conveyor referred to in the following illustration and description may be a conveyor using rollers each consisting of an array of small discs of which the length is smaller than the diameter (so-called "ring conveyer").

The roller conveyor 2 has a double structure consisting of an upper roller row 2u and lower roller row 2d. The substrates are passed through between the upper and lower roller rows 2u and 2d. The roller conveyor 2 is provided extending through the etching chamber provided with an etchant bath 3. Upper etchant spray nozzles 6u are disposed above the substrate path below which lower etchant spray nozzles 6d are disposed. The etchant in the bath 3 is sucked and pumped by a pump (not illustrated), and sprayed from the spray nozzles 6u and 6d to the substrates being moved through the etching chamber. The roller conveyor 2 brings the substrates having passed through the etching chamber further into a cleaning chamber 4 consisting of a water bath 4a, water pump 4b and water spray nozzles 4c. The etchant bath 3 has provided therein a cooling coil 8 and a heater (not illustrated) to control the temperature of the etchant.

While being carried on the roller conveyor 2 from the left to right of the drawing and passing above the etchant bath 3, the substrates are applied with the spray of etchant from above and below and thus etched on both sides thereof. As shown in Fig. 1, a window 9 for observing the etching process is provided.

In the prior-art substrate etching system shown in Fig. 1, the substrates being carried are applied uniformly on both sides thereof with the spray of etchant. In the etching system, spray nozzle tubes 6a and 6b having the etchant spray nozzles 6u and 6d, respectively, are oscillated by an oscillating device 7, and the substrates pass in sequence before the spray nozzles 6u and 6d. Therefore, the etchant can be sprayed to the substrates with an adequate uniformity required in practice.

However, the sprayed etchant falls or drops in a considerably different manner at the substrate upper side from at the lower side. More specifically, the etchant sprayed to the lower side of the substrates will rapidly drop, while the etchant sprayed to the substrate upper side will not easily fall and will stand there because the substrates are held horizontally. Such residual etchant will spoil the total uniformity of the etching, namely, it will cause a nonuniform etching.

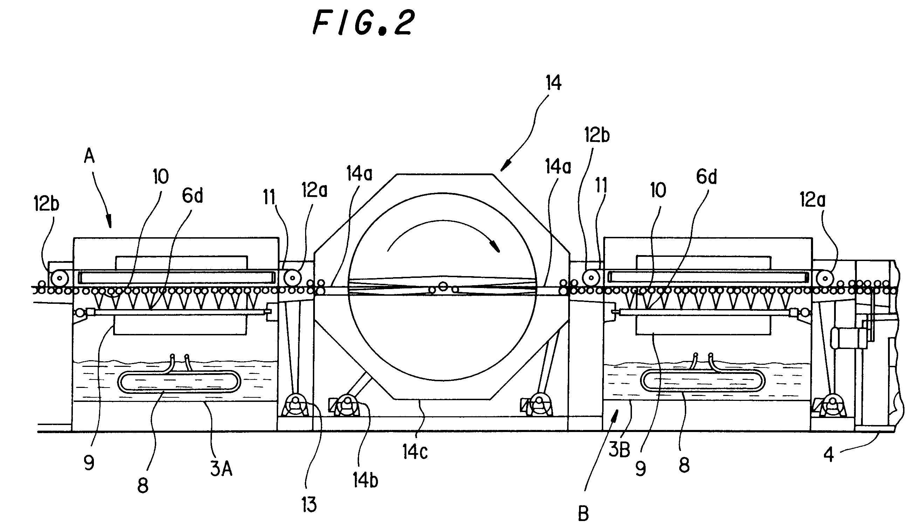

To avoid the above-mentioned nonuniform etching, an improved substrate etching method and system have been proposed as disclosed in the Japanese Unexamined Patent Publication No. 6-302935 (published on October 28, 1994). This substrate etching system is shown in Fig. 2 as a typical one.

This prior-art substrate etching method comprises the steps of spraying an etchant, from below only, to substrates being horizontally held and carried, to etch one side of the substrates; reversing upside down the substrates of which the one side has been etched in the preceding process; and spraying the etchant, also from below only, to the reversed substrates being horizontally held and carried, to etch the other side yet to etch of the substrates.

The substrate etching system comprises a means of horizontally holding and carrying substrates; a means disposed in the middle of the conveying means to reverse upside down the substrates being carried; and means disposed upstream and downstream, respectively, of the reversing means to spray the etchant, from below only, to the substrates being horizontally held and carried.

In this improved prior-art substrate etching system, the etchant is always sprayed only to the lower side of the horizontally held substrates, but not to the upper side. The etchant thus sprayed to the lower side of the substrates will be allowed to drop under the effect of the gravity, resulting in no nonuniform etching. The substrates are not applied at the upper side thereof with the spray of etchant. Thus, both sides of the substrates are totally etched with an almost complete uniformity.

Substrate etching using the substrate etching method and system known from the disclosure in the Japanese Unexamined Patent Publication No. 6-302935 will be further described below with reference to Fig. 2. The cleaning post, cooling coil and observation window indicated with same references (4, 8 and 9, respectively) as in Fig. 1 are identical or similar to those in Fig. 1.

The etching chamber of this etching system consists of a first etching station A provided with an etchant bath 3A, and a second etching station 3B provided with an etchant bath 3B. A substrate reversing mechanism 14 is disposed between the first and second etching stations 3A and 3B.

There is provided above either of the etchant baths 3A and 3B a roller conveyor 10 adapted to horizontally hold and carry substrates (not shown) in a direction from the left to right of the drawing. There is provided right above each roller conveyor 10 an endless rubber belt 11 similar to a belt conveyor and wound over a driving pulley 12a and driven pulley 12b. The endless rubber belt 11 is automatically driven to rotate. The substrates are carried through between the roller conveyor 10 and endless rubber belt 11.

Lower etchant spray nozzles 6d are provided in a row below each of the roller conveyors 10 to spray the etchant to the lower side of the substrates.

The configuration of the etching system disclosed in the Japanese Unexamined Patent Publication No. 6-302935 has been described in the foregoing.

The above etching system etches substrates as will be described below:

First, substrates having been carried into the etching chamber A are passed through between the roller conveyor 10 and endless rubber belt 11 toward the right of the drawing. During this conveyance, the substrates are applied with an etchant spray from below and etched at the lower side thereof. As having been described above, the etchant sprayed on the substrate lower side drops and is recirculated with no stagnancy on the substrate lower surface, so that the lower side can be etched uniformly. At this time, the substrates are allowed to have such a close contact, at the upper side thereof, with the endless rubber belt 11 that no sprayed etchant will come to the upper side which could not be etched uniformly, because the sprayed etchant will not easily leave the upper side of substrates, in the substrate etching systems in which an etchant is sprayed onto both sides of substrates simultaneously.

It should be noted that reference to the sides of a substrate as "upper" and "lower", respectively, is not based on the electrical properties and mechanical construction of the substrate. The up-oriented side of the horizontally held substrate is called "upper side" and the down-oriented side is called "lower side".

The substrates having the lower side thereof etched while being passed through the etching chamber A is carried on a belt conveyor 14a into a substrate reversing mechanism 14 which in turn will have a drive motor 14b thereof actuated to turn a turning drum 14c by 1/2 turn until the substrates are reversed upside down. The substrates thus reversed are carried on the belt conveyor 14a from the substrate reversing mechanism 14 toward the right of the drawing into the etching chamber B.

The etching chamber B is constructed similarly to the above-mentioned etching chamber A. This chamber B receives the substrates held horizontally and having the etched side thereof oriented upward and the side yet to etch thereof oriented downward. While being carried horizontally toward the right of the drawing, the substrates have the yet-to-be-etched side thereof etched with a spray of etchant from the lower etchant spray nozzles 6d.

While the substrates are passing through the etching chamber B, the substrates have the already etched upper side thereof protected under an endless rubber belt 11 in such a manner that the endless rubber belt 11 will not be affected by the etching of the lower side. When having passed through the etching chamber B, the substrates will have both sides thereof thus etched uniformly. The substrates are carried into the cleaning post 4 where they will be cleaned with water.

Through many application tests and studies of the above conventional substrate etching method and system in Fig. 2, the Inventor of the present invention recognized that the nonuniform etching could be avoided in the industrial application of the method and system, but also that the prior-art method and system had the following new problems.

The substrate reversing mechanism 14 provided between the two etching chambers A and B to reverse the substrates so that only the lower side of substrates will be applied with the etchant spray, will be adversely influenced by the etchant falling from the substrates and sticking to the reversing mechanism 14 during reversing of the substrates. When the etchant drops sticking to the reversing mechanism are dry, the etchant is crystallized and precipitates to possibly hinder the substrate reversing mechanism from operating smoothly.

### SUMMARY OF THE PRESENT INVENTION

Accordingly, it is an object of the present invention to provide a substrate etching method in which the substrate reversing mechanism is not likely to be hindered from smoothly operating, by any crystallized and precipitated etchant sticking to the reversing mechanism.

It is another object of the present invention to provide a substrate etching system suitable for carrying out the substrate etching method according to the present invention.

The above object is accomplished by providing a substrate etching method comprising, according to the present invention, a first etching step in which an etchant is sprayed onto one side of each of substrates being carried and having the other side thereof covered against application of the etchant spray, a step in which residual etchant is removed from the etched side of the substrates, a step in which the substrates are reversed upside down, a second etching step in which the etchant is sprayed onto the side, thus oriented downward and yet to etch, of the substrates being carried and having the etched upper side thereof covered against application of the etchant spray, and a step in which the substrates having been etched at both side thereof in the first and second steps are cleaned with water and dried.

In the process of etching by the above method, the substrates are etched at one side thereof while being covered at the other side with a surface protective member, the etchant sticking to the substrates is removed, the substrates are reversed upside down, and then the side, thus oriented downward and yet to etch, of the substrates are etched while the other side is being covered. Thus, the substrates can be etched uniformly at both sides thereof. Since the substrates have one side thereof etched and then are subjected to removal of residual etchant from the etched side thereof before they are etched at the other side thereof, no etchant will possibly stick to the substrate reversing mechanism.

The substrate etching system to carry out the above method comprises a means of horizontally holding and conveying substrates of which one side is exposed at least partially thereof; a first etching means disposed below the conveying means and provided with spray nozzles to apply an etchant spray to the one side of the substrates being conveyed; a surface protecting means disposed on the conveying means oppositely to the first etching means so as to be in close contact with the substrates on the conveying means and movable at a same speed as the conveying means; a means of removing the etchant sprayed to the one side of substrates, etched by the first etching means, and staying there; a means disposed in the route of the conveying means to reverse upside down the substrates having the sprayed etchant removed by the etchant removing means; a second etching means disposed below the conveying means and provided with spray nozzles to apply an etchant spray to the side, oriented downward and yet to etch, of the substrates thus reversed upside down by the substrate reversing means; and a means of cleaning and drying the etched substrates.

In the above substrate etching system, the substrates have one side thereof etched, they have the residual etachant removed from the etched side thereof and then passed into the substrate reversing mechanism, they are reversed upside down by the reversing mechanism, they are etched at the other side thereof. Therefore, the etchant will not possibly stay sticking to the substrate reversing mechanism which will thus not be hindered, by any residual etchant thereon, from operating smoothly.

The object of the present invention is accomplished by removing, from the substrates before upside-down reversing, the etchant which would otherwise drop down and stick to the reversing mechanism and hinder the latter from operating smoothly. In the present invention, "removal of etchant" does not mean any complete dry state in which no water is retained, but a dry state with retention of some water. That is, the etchant removal includes both a completely dry state and incompletely dry state.

These objects and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a vertical sectional view of a conventional etching system of a type in which a plurality of substrates is horizontally held and carried, and applied with a spray of an etchant, schematically showing the essential parts of the system;
Fig. 2 is a vertical sectional view of an improved example of the conventional substrate etching system in Fig. 1;
Fig. 3 is a plan view of an embodiment of the substrate etching system according to the present invention;
Fig. 4 is a schematic side elevation of the substrate etching system in Fig. 3;
Fig. 5 is a side elevation showing an etching station, conveyor and surface protective member;
Fig. 6 is a side elevation showing, as enlarged in scale, an etchant removing station consisting of a cleaning post and drying post;
Fig. 7 is a plan view of etching spray nozzle tubes disposed in the etching station; and
Fig. 8 is an end view for explanation of the structure of the spray nozzle tubes of the substrate etching system.

### DETAILED DESCRIPTION OF THE PREFERRED EMBODIMENTS

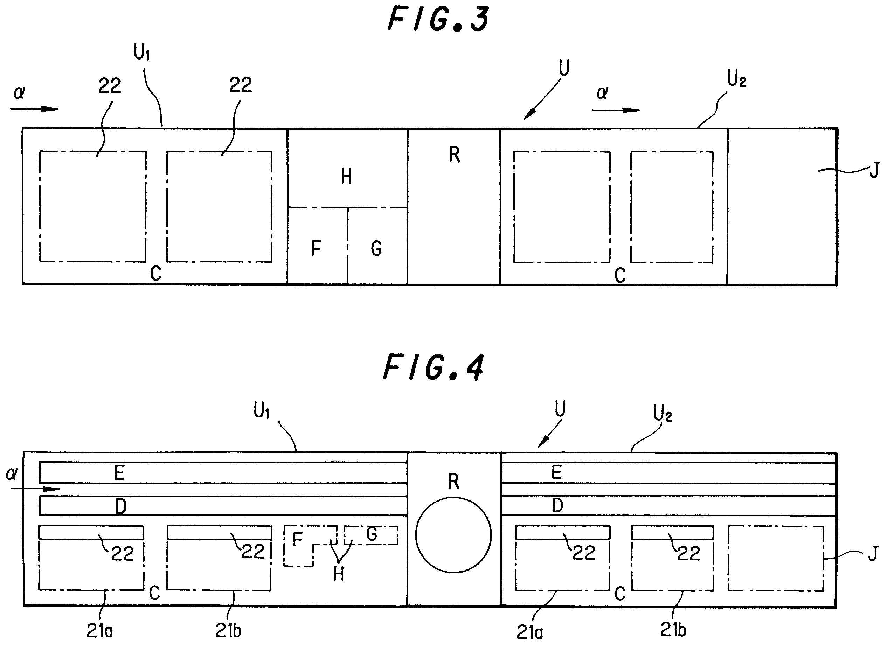

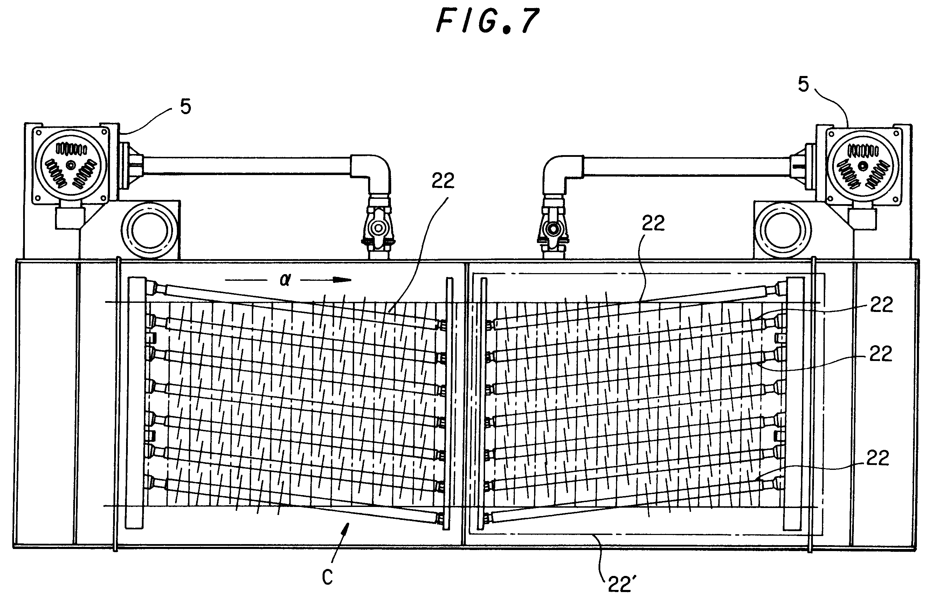

Referring now to Figs. 3 to 8 showing together one embodiment of the substrate etching system according to the present invention, the present invention will be described in detail below.

In Figures, the substrate etching system according to the present invention is indicated generally with a reference U. It is composed of an etching unit U1, substrate reversing mechanism R, and an etching unit U2. These components are disposed in line with each other. The etching unit U1 is composed of an etching station C consisting of two etchant baths 21a and 21b, a conveyor D, a surface protector E, and an etchant removing station H consisting of a cleaning post F and drying post G. The etching unit U2 is composed of an etching station C consisting of two etchant baths 21a and 21b, a conveyor D, a surface protection E and a cleaning/finishing station J.

The conveyor D is provided extending through the etching unit U1, substrate reversing mechanism R and the etching unit U2 generally horizontally along the length of the etching system U. The conveyor D defines a substrate path extending from the left to right of the drawing, which is indicated with an arrow α. In the etching unit U1, the etching station C is disposed below the conveyor D and has a plurality of etchant spray nozzle tubes 22. The substrates (not shown) is applied to the lower side thereof with a spray of the etchant from the spray nozzle tubes 22 while being horizontally held and carried on the conveyor D with the lower side of the substrates at least partially exposed. During this conveyance and spraying, the upper side of the substrates is covered with the surface protector E moving at a same speed as the conveyor D, and it will thus not be applied with the etchant spray.

After the substrates are etched at the upper side thereof in the etching station C of the etching unit U1, it is passed to the etchant removing station H (consisting of the cleaning post F and drying post G as mentioned above) in which it is subject to removal of residual etchant. Thereafter, the substrates are passed horizontally into the substrates reversing mechanism R where it is reversed upside down.

The etching unit U2 has provided under the conveyor D the etching station C identical to that in the etching unit U1. The substrates are horizontally held and carried on the conveyor D with the side, oriented by the substrates reversing mechanism R and yet to etch thereof exposed at least partially. Also in this unit U2, the lower side yet to etch of the substrates is applied with a spray of the etchant from the etchant spray nozzle tubes 22. During this conveyance and spraying, the already etched upper side of the substrates is covered with the surface protector E moving at a same speed as the conveyor D, and it will thus not be applied with the etchant spray.

The substrates thus etched in the etching stations C of the etching units U1 and U2 is fed into the cleaning/finishing station J where it is subject to cleaning and drying.

Etching at one side of the substrates in the etching unit U1 will mainly be described below. Etching of the substrates at the other side thereof in the etching unit U2, which is to be done after the substrates are reversed by the substrate reversing mechanism R, will not.

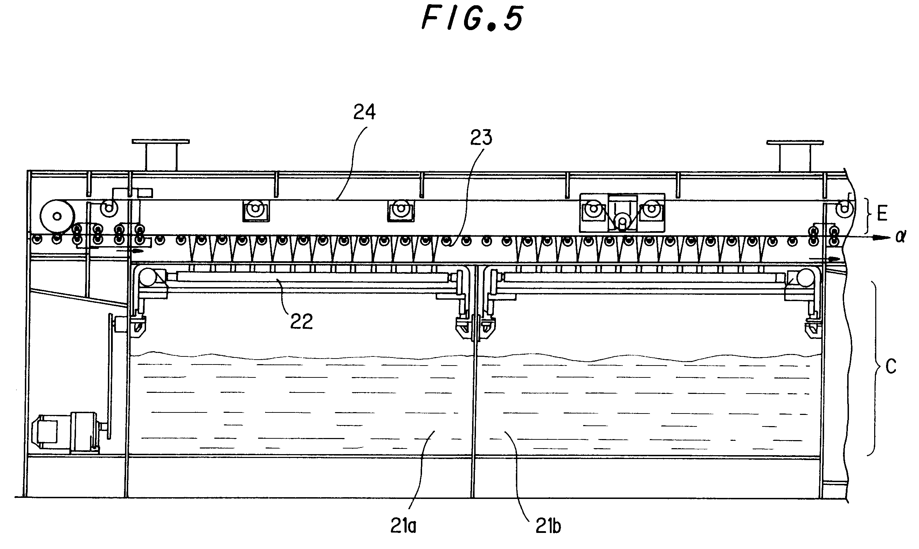

As shown in Fig. 5, the substrate conveyor D is composed of a roller conveyor 23. The conveyor should preferably be of such a structure as to horizontally hold and carry the substrates with the lower side of the substrates being exposed at least partially. The roller conveyor may be a ring conveyor, for instance. It should be noted that the "horizontally" often referred to herein does not strictly mean a completely horizontal state but it includes a slight gradient for draining. This wording means a "substantially horizontal" state.

The surface protector E consists of an endless rubber belt 24. While being kept in close contact with the upper side of the substrates (not shown) carried on the roller conveyor 23 in the direction of arrow α, the endless rubber belt 24 rotates at a same speed as the substrates being carried on the roller conveyor 23. It should be noted that the endless rubber belt 24 may be driven to rotate by means of the substrates on the roller conveyor 23. In this embodiment, however, the endless rubber belt 24 is driven to rotate by a drive motor 30. This driving configuration is advantageous because there will take place no slipping between the endless rubber belt 24 and substrates.

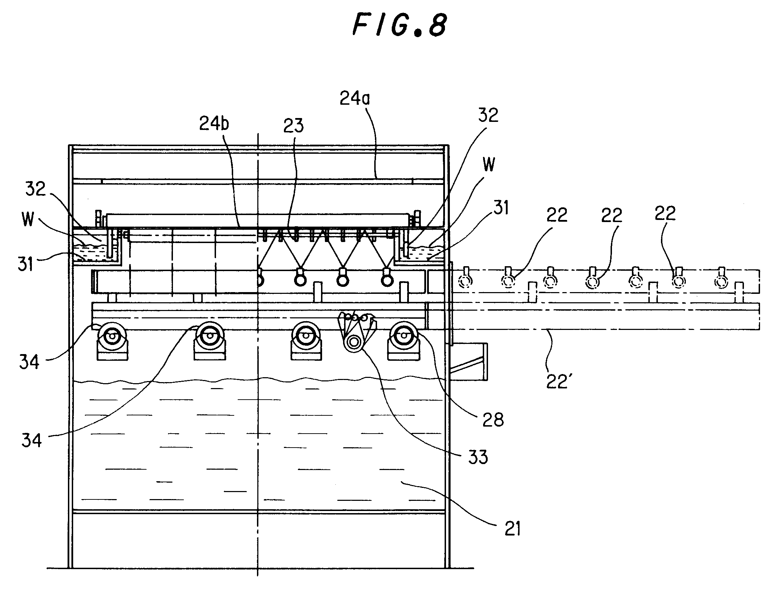

Each of the etchant baths 21a and 21b stores the etchant. As mentioned previously, it composes the etching station C together with an etchant pump 5, etchant spray nozzle tubes 22, and etchant spray nozzle tube frames 22' which will be further described later. The etchant is sucked and pumped by the pump 5, and sprayed upward from spray nozzles formed in the etchant spray nozzle tubes 22. The etchant spray is thus applied to the lower side of the substrates through the spaces between the rollers of the conveyor 23. The etchant spray nozzle tubes 22 are parallel to each other, and extend horizontally and at a small angle with respect to the substrate path (indicated with the arrow α). Thus, the etchant is sprayed uniformly to the lower side of the substrates conveyed in the direction of arrow α. The etchant spray nozzle tubes 22 are removably interconnected with each other by frame members to form the etchant spray nozzle tube frame 22'. The etchant spray nozzle tube frames 22' are supported on rollers 34 as shown in Fig. 8 and also guided by the rollers 34 for movement from the left to right of the drawing (in a horizontal direction at a right angle with respect to the substrate path). Each of the etchant spray nozzle tube frames 22' is reciprocated over short strokes by an oscillating mechanism 33 to attain a higher uniformity of substrate etching. The etchant spray nozzle tube frames 22' can conveniently be drawn laterally out of the substrate etching system as indicated with a dashed line in Fig. 8 for easy inspection, cleaning and replacement of the spray nozzle tubes 22.

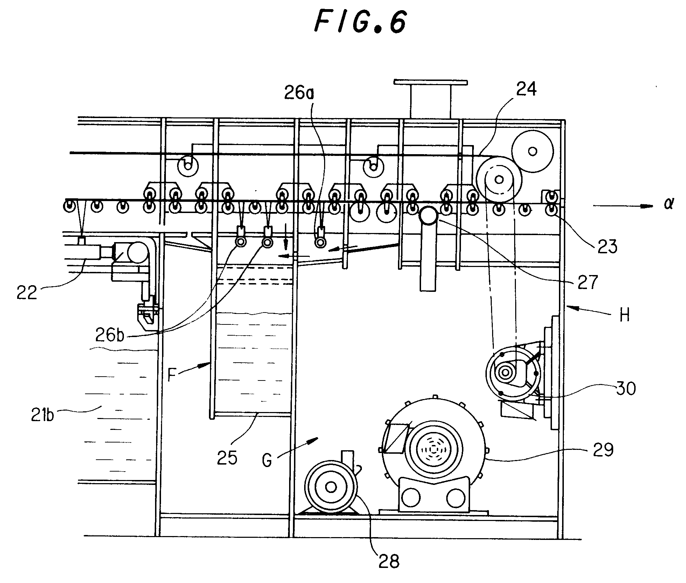

As shown in Fig. 6, there are disposed downstream of the etchant bath 21b in the moving direction (indicated with the arrow α) on the roller conveyor 23 the cleaning post F and drying post G which form together the etchant removing station H in which the residual etchant is removed from the etched lower side of the substrates. First, the water in a water bath 25 is sprayed to the etched lower side of the substrates from a recirculated-water spray nozzle tubes 26b, and then fresh water in a fresh-water spray nozzle tube 26a is sprayed to the lower side of the substrates. After the cleaning, the water is collected into the water bath 25. The water in this bath 25 is sucked and pumped by the water pump 28, and sprayed to the substrates from the recirculated-water spray nozzle tubes 26b to wash away the residual etchant on the lower side of the substrates.

There is provided at an oblique lower position on either side of a lower pass 24b of the endless rubber belt 24 a water collecting trough 31 extending in parallel to the substrate path (perpendicular to the plane of Fig. 8). The cleaning water sprayed to the substrates from the fresh-water spray nozzle tube 26a of the cleaning post F falls into the troughs 31 and flows into the water bath 25 from there. The liquid level in the water trough 31 is indicated with a reference W.

Each of the troughs 31 has a vertical sealing plate 32 disposed therein extending perpendicularly to the liquid level W. The sealing plate 31 used in this embodiment lies vertically and has a rectangular shape extending perpendicularly to the plane of Fig. 8. Its lower half is immersed below the liquid level W and its top end is nearly in contact with the lower pass 24b of the endless rubber belt 24. Thus, the sealing plates 31 work effectively to shut off odors by preventing the etchant vapor from going out to the atmosphere.

The drying post G has provided therein a blower 29 having a blower tube 27 from which dry air is blown to the cleaned substrates. The substrates are thus dried and all the residual etchant is cleared from on the lower side of the substrates.

In the foregoing, the etchant removing station H has been described to comprise the cleaning post F and drying post G. However, the etchant removing means according to the present invention is not limited to such configuration, but it may be any other mechanism which could wipe off the etchant from on the substrates.

Fig. 6 shows the right end portion of the endless rubber belt 24 shown in Fig. 5. The endless rubber belt 24 is wound on the drive pulley driven by the drive motor 30. It keeps a close contact with the upper side of the substrates until the lower side of the substrates is completely dried in the etchant removing station H. Fig. 8 shows the upper pass 24a and lower pass 24b of the endless rubber belt 24. The lower side of the lower pass 24b of the endless rubber belt 24 has a close contact with the upper side, yet to etch, of the substrates to protect it against application of the etchant spray.

The substrates having passed through the etchant removing station H are carried into the substrate reversing mechanism R by the roller conveyor 23. The substrate reversing mechanism R in this embodiment has a same configuration as the conventional substrate reversing mechanism 14 having previously been described and illustrated with reference to Fig. 2. More specifically, when the substrates are carried into the turning drum of the mechanism R, the drive motor is put into action to turn the turning drum a half turn so that the substrates are reversed upside down. Then, the substrates are carried out by the roller conveyor 23 toward the right of the drawing and into the etching unit U2. At this time, the substrates are not yet etched at the lower side thereof. The substrates carried into the etching unit U2 and having the side, thus oriented downward and yet to etch, thereof are etched in the etching station C with the lower side of the lower pass 24b of the endless rubber belt 24 being kept in close contact with the already etched side of the substrates. Thereafter, the substrates are moved to the cleaning/finishing station J in which it totally cleaned with water and dried.

As having been described in the foregoing, since one side, and then the other side, of the substrates are etched separately with the etchant sprayed from below, the substrates can be etched uniformly. Also, since one previously etched side of the substrates is cleaned to remove the residual etchant and then the other side yet to etch is etched, there is no possibility for the etchant falling from the substrates to stick to the substrate reversing means of a whatever type used between the two etching units.

In the substrate etching system according to the present invention, the etchant removing station H provided downstream of the etching station in the substrate path removes effectively the etchant from the substrates having one side thereof etched, before the substrates are carried into the substrate reversing mechanism R. Therefore, there is no possibility for the etchant to stick to the substrate reversing mechanism and hinder the mechanism from operating smoothly. Since the smooth operation of the substrate reversing mechanism can be thus assured, the substrates can be etched uniformly.

According to its broades aspect the invention relates to a method for etching substrates comprising the steps of:
spraying the etchant to one side of the substrates; and
removing residual etchant from said etched side of said substrates.

## Claims

1. A method for etching substrates for printed circuit boards, in which to form predetermined circuits on both sides of substrates, one side, and then the other side, of the substrates being horizontally held and conveyed, are etched, separately, with an etchant spray, respectively, comprising the steps of:
spraying the etchant to one side of the substrates being carried with the other side of said substrates being covered against application of the etchant spray;
removing residual etchant from said etched side of said substrates;
reversing said substrates upside down;
spraying the etchant to the side, thus oriented downward and yet to etch, of said substrates being carried with said etched side being covered against application of said etchant spray; and
cleaning and drying said substrates having been etched at both sides thereof by the first and second steps of etching, respectively.

2. A substrate etching method as set forth in Claim 1, wherein in said first and second steps of etching, an endless rubber belt kept in close contact with the one side of said substrates is rotated at a same speed as the moving speed of said substrates.

3. A system for etching substrates for printed circuit boards, comprising:
a means of horizontally holding and conveying the substrates of which one side is exposed at least partially;
a first etching means disposed below said conveying means and provided with spray nozzles to spray an etchant to the one side of said substrates being conveyed;
a surface protecting means disposed over said conveying means oppositely to said first etching means so as to be in close contact with said substrates on said conveying means movably at a same speed as said conveying means;
a means of removing said etchant sprayed to said one substrate side by said first etching means and staying there;
a means disposed in the path of said conveying means to reverse upside down said substrates having the sprayed etchant removed by said etchant removing means;
a second etching means disposed below said conveying means and provided with spray nozzles to spray the etchant to the lower side yet to etch of said substrates having been reversed upside down by said substrate reversing means; and
a means of cleaning and drying said etched substrates.

4. A substrate etching system as set forth in Claim 3, wherein said conveying means is a roller conveyor consisting of a plurality of rollers disposed as regularly spaced on the conveying path and it is so constructed as to spray the etchant from said first and second etching means through the spaces between said plurality of rollers.

5. A substrate etching system as set forth in Claim 3, wherein said surface protecting means is an endless rubber belt rotatable at a same speed as said conveying means and which is in close contact with the upper side of said substrates being conveyed.

6. A substrate etching system as set forth in Claim 3, wherein said etchant removing means comprises a means of spraying water to the lower side of said substrates being conveyed to remove the residual etchant from said substrates, and a means of blowing air to said cleaned side of the substrates.

7. A substrate etching system as set forth in Claim 6, wherein said cleaning means comprises spray nozzles to spray fresh water to said substrates, a water bath to collect and store the water sprayed and dropped, and spray nozzles to spray the recirculated water in said water reservoir to clean said substrates.

8. A substrate etching system as set forth in Claim 7, wherein water collecting troughs are provided extending from said fresh-water spray nozzles in parallel with the substrate path to collect the water sprayed to and dropped from said substrates to direct the recirculated-water into said water bath and a sealing plate is disposed so as to intersect the water in said water collecting trough.

9. A method for etching substrates comprising the steps of:
spraying the etchant to one side of the substrates; and
removing residual etchant from said etched side of said substrates.
